# EUROPÄISCHE PATENTSCHRIFT

(11) **EP 0 917 741 B1**
(45) Veröffentlichungstag und Bekanntmachung des Hinweises auf die Patenterteilung: **31.10.2001**
(21) Anmeldenummer: 97936591.3
(22) Anmeldetag: 04.08.1997
(51) Int. Cl.: H01L 33/00, H01L 21/20

(54) **VERFAHREN ZUR HERSTELLUNG EINER INFRAROTEMITTIERENDEN LUMINESZENZDIODE**
PROCESS FOR MANUFACTURING AN INFRARED-EMITTING LUMINESCENT DIODE
PROCEDE DE FABRICATION D'UNE DIODE LUMINESCENTE EMETTANT DES INFRAROUGES

(30) Priorität: 07.08.1996 DE 19631906
(43) Veröffentlichungstag der Anmeldung: 26.05.1999
(73) Patentinhaber: Osram Opto Semiconductors GmbH & Co. OHG, 93049 Regensburg (DE)
(72) Erfinder: SEDLMEIER, Reinhard, D-93073 Neutraubling (DE); NIRSCHL, Ernst, D-93173 Wenzenbach (DE); STATH, Norbert, D-93049 Regensburg (DE)
(74) Vertreter: Epping, Wilhelm, Dipl.-Ing.
(86) Internationale Anmeldenummer: DE9701641
(87) Internationale Veröffentlichungsnummer: WO9806133

(56) Entgegenhaltungen:
- EP-A- 0 325 493
- EP-A- 0 420 691
- US-A- 5 070 510

## Beschreibung

Die Erfindung bezieht sich auf ein Verfahren zur Herstellung einer infrarotemittierenden Lumineszenzdiode, bei der auf einem Halbleitersubstrat, vorzugsweise bestehend aus GaAs, eine im Betrieb der Lumineszenzdiode eine Infrarot(IR)-Strahlung aussendende aktive Schichtenfolge aufgebracht wird, die ausgehend vom Halbleitersubstrat eine erste AlGaAs-Mantelschicht, eine GaAs und/oder AlGaAs enthaltende aktive Schicht und eine zweite AlGaAs-Mantelschicht aufweist.

Lumineszenzdioden bzw. lichtemittierende Dioden (LEDs) werden als Sendeelemente insbesondere bei der optischen Nachrichtentechnik benötigt. In Abhängigkeit der gewünschten Wellenlänge des emittierten Lichtes werden unterschiedliche Halbleitersysteme verwendet, deren jeweils zugrunde liegenden Halbleitermaterialien auch unterschiedliche Herstellverfahren mit jeweils eigenständigen technologischen Problemstellungen nach sich ziehen. Im sichtbaren Spektralbereich mit Wellenlängen von etwa 400 bis 800 nm wird ein AlGaInP-Legierungssystem verwendet, bei dem durch Einstellung des Aluminiumgehaltes die gewünschte Wellenlänge aus einem relativ breiten Farbbereich festgelegt werden kann. Zu unterscheiden hiervon sind Lumineszenzdioden, die mit größeren Wellenlängen im Infrarotbereich arbeiten und in der Regel auf einem AlGaAs-System basieren, bei dem durch Einstellung des Aluminiumgehaltes im typischen Bereich von etwa 10 % bis 30 % Wellenlängen des emittierten Lichtes von oberhalb etwa 800 nm erreicht werden können. Die vorliegende Erfindung befasst sich mit der Herstellung solcher Infrarot-Lumineszenzdioden auf der Grundlage eines AlGaAs-Systems. Bei den bisherigen Infrarot-Lumineszenzdioden wurde die gesamte, auf das GaAs-Substrat aufzubringende Schichtenfolge vermittels LPE-(Flüssigphasenepitaxie)-Verfahren hergestellt. Bei diesem wird zur Ausbildung einer epitaktischen Schicht eine bei einer bestimmten Temperatur übersättigte Schmelze, welches sich aus den entsprechend gewünschten Dotiermaterialien zusammensetzt, mit dem Substratkristall aus GaAs, in Kontakt gebracht, so daß sich während einer anschließenden Abkühlung eine epitaktische Schicht von GaAs bzw. AlGaAs auf dem Substratkristall ausbildet. Auf diese Weise können entsprechend der Phasendiagramme einkristalline Schichten unterschiedlicher Zusammensetzung aufgewachsen werden. Das Flüssigphasenepitaxie-Verfahren besitzt relativ große Aufwachsraten und ist daher auch zur Herstellung relativ dicker Epitaxieschichten geeignet. Gerade im Zusammenhang mit der Herstellung der Schichtenfolge bei Infrarot-Lumineszenzdioden des hier interessierenden AlGaAs-Systems wird es als nachteilig angesehen, dass die nach dem bisherigen Verfahren abgeschiedenen, relativ dicken AlGaAs-LPE-Schichten zu mechanischen Spannungen und damit zu verbogenen Epi-Wafern führen, die bei nachfolgenden Technologieschritten schwer zu verarbeiten sind. Aus diesem Grunde ist das bisher verwendete Herstellverfahren von infrarotemittierenden Lumineszenzdioden im Waferverbund auf Halbleitersubstrate mit einem Waferdurchmesser von maximal 5,08 cm (zwei Zoll) begrenzt.

In Weitergestaltung der Erfindung sind die infrarotemittierenden Lumineszenzdioden mit einer sogenannten Auskopplungsschicht zur Verbesserung des optischen Auskopplungswirkungsgrades des von der Lumineszenzdiode abgestrahlten Lichtes ausgestattet. Der optische Auskopplungswirkungsgrad wird hierbei zunächst durch den Schichtaufbau des zugrunde liegenden Halbleitermaterials in hohem Maße bestimmt. Wenn die eigentliche Lichterzeugung in einer dünnen, zusammenfassend als aktive Schicht bezeichneten Schicht erfolgt, und beispielsweise wie bei Lumineszenzdioden mit Doppel-Hetero-Schichtstruktur eine sogenannte aktive Zone oder wie bei Homo-pn-Lumineszenzdioden eine um den pn-Übergang ausgebildete lichterzeugende Zone umfasst, so können beidseitig angeordnete Mantelschichten mit einem niedrigen Absorptionsgrad für die emittierte Wellenlänge den Auskopplungswirkungsgrad deutlich verbessern. Hierzu müssen bei der Herstellung der Schichtstruktur relativ dicke Halbleiterschichten mit höherem Bandabstand als in der lichterzeugenden Zone (aktiven Schicht) eingestellt aufgebracht werden. Die Herstellung solcher Strukturen wird derzeit in situ nur mit Flüssigphasenepitaxie-Verfahren (LPE) oder durch Kombination von verschiedenen Gasepitaxie-Verfahren (VPE) erzeugt, wobei bei letzterem die lichterzeugende Struktur in der Regel vermittels MOVPE-Verfahren und die dicke Auskopplungsschicht mittels VPE-Verfahren erzeugt wird. Ein Nachteil beim Einsatz des MOVPE-Verfahrens zur Herstellung von LED-Strukturen mit solchen dicken Auskopplungsschichten sind die vergleichsweise geringen Abscheideraten. Zur Herstellung relativ dicker Fensterschichten mit Dicken von etwa mehr als 10 µm bzw. Auskopplungsschichten, vorzugsweise aus GaAs, die eine besonders hohe Auskopplungswirkungsgradsteigerung ermöglichen, ist bisher die Kombination aus MOVPE-Verfahren und VPE-Verfahren im Einsatz. Erfindungsgemäß soll auch eine neue Verfahrenskombination angegeben werden, mit der sich LED-Strukturen mit dikken Auskopplungsschichten erzeugen lassen. Eine Schwierigkeit besteht hierbei unter anderem darin, daß sowohl die Zusammensetzung als auch die Herstellbedingungen für die Auskopplungsschicht auch den externen Wirkungsgrad beeinflussen, da durch die genannten Parameter das Ausmaß von Schädigungen der empfindlichen Schichtstrukturen (Doppel-Hetero-Schicht im Falle einer aktiven Zone, bzw. pn-Übergang) bestimmt wird.

Aus der US 5,233,204 bzw. aus K. H. Huang, et. al. Appl. Phys. Lett. 61 (9), 31. August 1992, Seiten 1045-1047 ist die Herstellung von Lumineszenzdioden im sichtbaren Spektralbereich der Wellenlängen 555 bis 620 nm auf der Grundlage eines AlGaInP-Legierungssystems bekannt geworden. Diese Lumineszenzdioden umfassen eine Schichtenfolge, die ausgehend von einem GaAs-Substrat eine erste AlGaInP-Mantelschicht vom n-Typ, eine aktive Zone aus AlGaInP vom n-Typ und eine zweite AlGaInP-Mantelschicht vom p-Typ aufweist. Die beiden Mantelschichten besitzen jeweils eine Dicke von etwa 800 nm, die aktive Zone besitzt eine Dicke von etwa 500 nm. Die erste AlGaInP-Mantelschicht, die aktive Zone, und die zweite AlGaInP-Mantelschicht werden vermittels einem MOCVD-(metallorganochemische Dampfabscheidung)-Verfahren hergestellt. Ferner bekannt ist es, oberhalb der zweiten AlGaInP-Mantelschicht eine vermittels einem VPE-(Gasphasenepitaxie)-Verfahren herzustellende optisch transparente Auskopplungsschicht aus GaP, AlGaAs, oder GaAsP mit einer Dicke von wenigstens 15 µm auszubilden. Die Auskopplungsschicht dient hierbei zur Vergrößerung der effektiven Lichtabstrahlung der Lumineszenzdiode durch Anheben der seitlich emittierten Lichtmenge und Verringern der durch das lichtabsorbierende Substrat absorbierten Lichtmenge. Die Auskopplungsschicht besitzt zu diesem Zweck eine Dicke von wenigstens 6% der Breite der Lumineszenzdiode. Der optische Brechungsindex der Auskopplungsschicht wird dabei so gewählt, dass der durch den Totalreflexionswinkel bestimmte, innerhalb der Lumineszenzdiode absorbierte Lichtanteil vermindert wird.

Der Erfindung liegt die Aufgabe zugrunde, ein Verfahren zur Herstellung einer infrarotemittierenden Lumineszenzdiode mit einem GaAs-Halbleitersubstrat und einer Schichtenfolge auf der Grundlage des AlGaAs-Systems zur Verfügung zu stellen, bei der auch bei Abscheidung relativ dicker AlGaAs-Schichten die erzeugten mechanischen Spannungen vermindert sind, und welche sich demzufolge auch für die problemlose Herstellung einer Vielzahl von Lumineszenzdioden im Waferverbund bei Waferdurchmessern von mehr als zwei Zoll eignet.

Diese Aufgabe wird durch das im Anspruch 1 angegebene Verfahren gelöst.

Vorteilhafte Weiterbildungen und Ausführungsformen des erfindungsgemäßen Verfahrens sind Gegenstand der Unteransprüche 2 bis 9.

Die Erfindung besteht darin, die erste AlGaAs-Mantelschicht und die aktive Zone vermittels einem MOVPE-(Metallorganogasphasenepitaxie)-Verfahren und die zweite AlGaAs-Mantelschicht vermittels einem LPE-(Flüssigphasenepitaxie)-Verfahren herzustellen. Die erfindungsgemäße Verfahrenskombination aus MOVPE und LPE bei der Herstellung einer infrarotemittierenden Lumineszenzdiode auf der Grundlage des AlGaAs-Systems besitzt gegenüber den bisher verwendeten Verfahren folgende Vorteile:

Im Sinne einer optimalen strukturellen Anpassung, welche für eine gute Ladungsträgermobilität und hohe Lebensdauer der epitaktischen Schichten wesentlich ist, werden die im Hinblick auf mechanische Spannung besonders kritische erste AlGaAs-Mantelschicht und die aktive Schicht vermittels einem MOVPE-Verfahren gefertigt, bei dem das verwendete Metall über einen Transport in der Gasphase vermittels vorzugsweise Trimethylgallium als Trägergas bei niedrigem Dampfdruck stattfindet. Die Abscheidung findet dabei weit unterhalb des Schmelzpunktes des GaAs-Kristalls statt, wodurch der Einbau von Verunreinigungen aus dem Epitaxie-System deutlich unterdrückt wird. Bei einer Gesamtdicke des aktiven Schichtaufbaus, bestehend aus den Mantelschichten und der aktiven Zone von typischerweise etwa 10 µm sind die beim MOVPE-Verfahren verfügbaren Abscheideraten noch ausreichend hoch. Für die Herstellung der zweiten AlGaAs-Mantelschicht wird das LPE-Verfahren gewählt, welches einfacher und kostengünstiger durchzuführen ist und wesentlich höhere Abscheideraten bietet, daher insbesondere für größere Schichtdicken geeignet ist. Derart hergestellte Epi-Wafer weisen nach deren Herstellung eine bedeutend geringere Verbiegung auf als Epi-Wafer, die nach den bislang bekannten Verfahren hergestellt wurden.

Zur Herstellung relativ dicker Fensterschichten bzw. Auskopplungsschichten mit Dicken von etwa mehr als 10 µm oder sogar von selbsttragenden Auskopplungsschichten mit Dicken von etwa mehr als 70 µm auf der zweiten Mantelschicht wird dem Prinzip der Erfindung folgend vorgeschlagen, eine Verfahrenskombination von MO-Gasphasenepitaxie für die erste Mantelschicht und die aktive Schicht, und von Flüssigphasenepitaxie für die zweite Mantelschicht und die Auskopplungsschicht vorzusehen, welche eine neue, vorteilhafte Realisierung zur Herstellung der gewünschten infrarotemittierenden Lumineszenzdioden bietet, wobei für die Flüssigphasenabscheidung insbesondere solche LPE-Verfahrensvarianten angewendet werden, die eine möglichst geringe thermische Belastung des lichterzeugenden Schichtaufbaues nach sich ziehen, also beispielsweise ein Temperaturdifferenz-LPE-Verfahren. Durch nachfolgendes Abätzen bzw. Ablösen des im Falle von GaAs absorbierenden Substrates wird erreicht, dass derart hergestellte IR-Lumineszenzdioden einen besonders hohen Auskopplungswirkungsgrad aufweisen.

Weitere Merkmale, Vorteile und Zweckmäßigkeiten der Erfindung ergeben sich aus der nachfolgenden Beschreibung von Ausführungsbeispielen anhand der Zeichnung. Es zeigt:
- Figur 1: eine schematische Schnittdarstellung einer IR-Lumineszenzdiode gemäß einem ersten Ausführungsbeispiel der Erfindung;
- Figur 2: eine schematische Schnittdarstellung einer IR-Lumineszenzdiode gemäß einem zweiten Ausführungsbeispiel der Erfindung; und
- Figur 3: eine schematische Schnittdarstellung einer IR-Lumineszenzdiode gemäß einem dritten Ausführungsbeispiel der Erfindung.

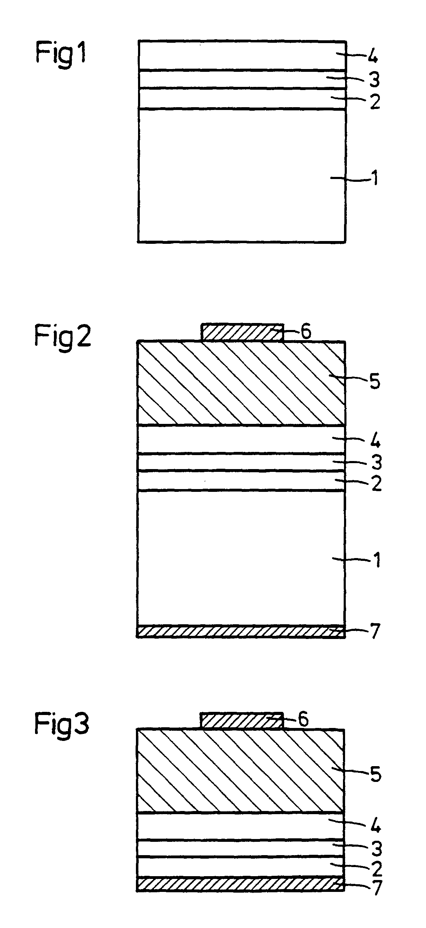

Das in Figur 1 dargestellte Ausführungsbeispiel einer nach dem erfindungsgemäßen Verfahren hergestellten infrarotemittierenden Lumineszenzdiode umfasst ein Halbleitersubstrat 1 aus GaAs, auf welchem eine im Betrieb der Lumineszenzdiode eine IR-Strahlung aussendende aktive Schichtenfolge aufgebracht ist, die ausgehend vom Halbleitersubstrat 1 eine erste AlₓGa₁₋ₓAs-Mantelschicht 2 mit x = 0,35, eine aktive Schicht 3 und eine zweite AlₓGa₁₋ₓAs-Mantelschicht 4 mit x = 0,35 aufweist. Die aktive Schicht 3 nach dem Ausführungsbeispiel gemäß Figur 1 stellt eine AlGaAs-Doppel-Heterostruktur mit einer Wellenlänge der emittierten IR-Strahlung von etwa 830 nm dar; alternativ kann die aktive Schicht 3 auch durch einen Homo-pn-Übergang ausgebildet sein. Der in Figur 1 dargestellte Schichtaufbau eignet sich insbesondere für die Herstellung besonders schneller infrarotemittierenden Lumineszenzdioden.

Die erste AlₓGa₁₋ₓAs-Mantelschicht 2 und die aktive Schicht 3 werden vermittels einem MOVPE-(Metallorganogasphasenepitaxie)-Verfahren hergestellt, während die zweite AlₓGa₁₋ₓAs-Mantelschicht 4 vermittels einem LPE-(Flüssigphasenepitaxie)-Verfahren gefertigt wird.

Bei dem in Figur 2 dargestellten Ausführungsbeispiel ist zusätzlich eine AlₓGa₁₋ₓAs-Auskopplungsschicht 5 mit x = 0,2 - 0,4 oberhalb der zweiten AlₓGa₁₋ₓAs-Mantelschicht 4 abgeschieden, welche AlₓGa₁₋ₓAs-Auskopplungsschicht 5 vermittels einem LPE-(Flüssigphasenepitaxie)-Verfahren abgeschieden wird und eine Gesamtdicke von etwa 10 µm bis etwa 50 µm besitzt. Die Bezugsziffern 6 und 7 bezeichnen elektrisch leitende Elektrodenanschlüsse, die bei der Darstellung gemäß Figur 1 der Einfachheit halber weggelassen sind.

Bei dem Ausführungsbeispiel nach Figur 3 ist die AlₓGa₁₋ₓAs-Auskopplungsschicht 5 als selbsttragende Schicht mit einer Dicke von wenigstens etwa 50 µm ausgebildet, und das optisch absorbierende Substrat 1 durch Ätzen oder dergleichen Ablösungsschritt abgelöst. Bei diesem Ausführungsbeispiel dient die selbsttragende Auskopplungsschicht 5 gewissermaßen als transparentes Substrat, welches die Struktur bestehend aus den Schichten 2, 3, 4, sowie 6, 7 abstützt.

Die in den Figuren 2 und 3 dargestellten Ausführungsbeispiele eignen sich insbesondere zur Herstellung besonders heller infrarotemittierender Lumineszenzdioden.

### Bezugszeichenliste

- 1: Halbleitersubstrat
- 2: erste AlₓGa₁₋ₓAs-Mantelschicht
- 3: aktive Schicht
- 4: zweite AlₓGa₁₋ₓAs-Mantelschicht
- 5: AlₓGa₁₋ₓAs-Auskopplungsschicht
- 6, 7: elektrisch leitende Elektrodenanschlüsse

## Patentansprüche

1. Verfahren zur Herstellung einer infrarotemittierenden Lumineszenzdiode, bei der auf einem Halbleitersubstrat (1), vorzugsweise bestehend aus GaAs, eine im Betrieb der Lumineszenzdiode eine Infrarot-Strahlung aussendende aktive Schichtenfolge aufgebracht wird, die ausgehend vom Halbleitersubstrat (1) eine erste AlGaAs-Mantelschicht (2), eine GaAs und/oder AlGaAs enthaltende aktive Schicht (3) und eine zweite AlGaAs-Mantelschicht (4) aufweist, wobei die erste AlGaAs-Mantelschicht (2) und die aktive Schicht (3) vermittels eines MOVPE-(Metallorganogasphasenepitaxie)-Verfahrens hergestellt werden, **dadurch gekennzeichnet, dass** die zweite AlGaAs-Mantelschicht (4) vermittels eines LPE(Flüssigphasenepitaxie) -Verfahrens hergestellt wird.

2. Verfahren nach Anspruch 1, **dadurch gekennzeichnet, dass** die erste AlGaAs-Mantelschicht (2) und/oder die zweite AlGaAs-Mantelschicht (4) jeweils einen Al-Gehalt von 10 % bis 35 % aufweisen.

3. Verfahren nach Anspruch 1 oder 2, **dadurch gekennzeichnet, dass** die Herstellung einer Vielzahl von infrarotemittierenden Lumineszenzdioden im Waferverbund erfolgt, wobei der Wafer einen Durchmesser von mehr als 5,08 cm (zwei Zoll) besitzt.

4. Verfahren nach einem der Ansprüche 1 bis 3, **dadurch gekennzeichnet, dass** auf der zweiten AlGaAs-Mantelschicht (4) eine elektrisch leitfähige, im infraroten Spektralbereich optisch transparente Auskopplungsschicht (5) mit einer Dicke von wenigstens 10 µm vermittels einem LPE-(Flüssigphasenepitaxie)-Verfahren abgeschieden wird.

5. Verfahren nach Anspruch 4, **dadurch gekennzeichnet, dass** die Auskopplungsschicht (5) selbsttragend ausgebildet wird und eine Dicke von wenigstens 50 µm besitzt.

6. Verfahren nach Anspruch 5, **dadurch gekennzeichnet, dass** das vorzugsweise aus GaAs bestehende Halbleitersubstrat (1) nach Fertigung der selbsttragenden Auskopplungsschicht (5) abgelöst wird.

7. Verfahren nach Anspruch 5 oder 6, **dadurch gekennzeichnet, dass** die Auskopplungsschicht (5) aus AlGaAs mit einem Al-Gehalt von vorzugsweise 20 % bis 35 % besteht.

8. Verfahren nach einem der Ansprüche 5 bis 7, **dadurch gekennzeichnet, dass** die Auskopplungsschicht (5) in mehreren LPE-Einzelschritten gefertigt wird.

9. Verfahren nach einem der Ansprüche 4 bis 8, **dadurch gekennzeichnet, dass** die Auskopplungsschicht (5) mittels eines Temperaturdifferenz-LPE-Verfahrens hergestellt wird.

## Claims

1. Method for fabricating an infrared-emitting light-emitting diode in which an active layer sequence is applied on a semiconductor substrate (1), preferably composed of GaAs, said active layer sequence emitting infrared radiation during operation of the light-emitting diode and having, proceeding from the semiconductor substrate (1), a first AlGaAs cover layer (2), a GaAs- and/or AlGaAs-containing active layer (3) and a second AlGaAs cover layer (4), the first AlGaAs cover layer (2) and the active layer (3) being fabricated by means of an MOVPE (Metal Organic Vapour Phase Epitaxy) method, **characterized in that** the second AlGaAs cover layer (4) is fabricated by means of an LPE (Liquid Phase Epitaxy) method.

2. Method according to Claim 1, **characterized in that** the first AlGaAs cover layer (2) and/or the second AlGaAs cover layer (4) respectively have/has an Al content of 10% to 35%.

3. Method according to Claim 1 or 2, **characterized in that** a multiplicity of infrared-emitting light-emitting diodes are fabricated in the wafer composite, the wafer having a diameter of more than 5.08 cm (two inches).

4. Method according to one of Claims 1 to 3,
**characterized in that** an electrically conductive coupling-out layer (5) having a thickness of at least 10 µm is deposited on the second AlGaAs cover layer (4) by means of an LPE (Liquid Phase Epitaxy) method, said coupling-out layer being optically transparent in the infrared spectral region.

5. Method according to Claim 4, **characterized in that** the coupling-out layer (5) is designed to be self-supporting and has a thickness of at least 50 µm.

6. Method according to Claim 5, **characterized in that** the semiconductor substrate (1), preferably composed of GaAs, is removed after the self-supporting coupling-out layer (5) has been produced.

7. Method according to Claim 5 or 6, **characterized in that** the coupling-out layer (5) is composed of AlGaAs with an Al content of, preferably, 20% to 35%.

8. Method according to one of Claims 5 to 7,
**characterized in that** the coupling-out layer (5) is produced in a number of individual LPE steps.

9. Method according to one of Claims 4 to 8,
**characterized in that** the coupling-out layer (5) is fabricated by means of a temperature difference LPE method.

## Revendications

1. Procédé de fabrication d'une diode luminescente émettant dans l'infrarouge, dans lequel, sur un substrat semiconducteur (1), constitué de préférence de GaAs, on applique un empilement de couches actives qui, quand la diode luminescente est active, émet un rayonnement infrarouge, empilement qui, à partir du substrat semiconducteur (1), comporte une première couche de recouvrement (2) d'AlGaAs, une couche active (3) contenant du GaAs et/ou de l'AlGaAs, et une deuxième couche de recouvrement (4) d'AlGaAs, où la première couche de recouvrement (2) d'AlGaAs et la couche active (3) sont fabriquées par un procédé MOVPE (épitaxie en phase gazeuse par organométalliques), **caractérisé en ce que** la deuxième couche de recouvrement (4) d'AlGaAs est réalisée par un procédé LPE (épitaxie en phase liquide).

2. Procédé selon la revendication 1, **caractérisé en ce que** la première couche de recouvrement (2) d'AlGaAs et/ou la deuxième couche de recouvrement (4) d'AlGaAs ont chacune une teneur en Al de 10 à 35 %.

3. Procédé selon la revendication 1 ou 2, **caractérisé en ce que** la fabrication d'un grand nombre de diodes luminescentes émettant dans l'infrarouge est réalisée sous forme d'une tranche composite, la tranche ayant un diamètre supérieur à 5,08 cm (deux pouces).

4. Procédé selon l'une des revendications 1 à 3, **caractérisé en ce qu'**on dépose sur la deuxième couche de recouvrement (4) d'AlGaAs, par un procédé LPE (épitaxie en phase liquide) une couche de découplage (5), conductrice de l'électricité, optiquement transparente dans la partie infrarouge du spectre, ayant une épaisseur d'au moins 10 µm.

5. Procédé selon la revendication 4, **caractérisé en ce que** la couche de découplage a une structure autoportante et une épaisseur d'au moins 50 µm.

6. Procédé selon la revendication 5, **caractérisé en ce que** le substrat semiconducteur (1), constitué de préférence de GaAs, est détaché après fabrication de la couche de découplage autoportante (5).

7. Procédé selon la revendication 5 ou 6, **caractérisé en ce que** la couche de découplage (5) est constituée d'AlGaAs avec une teneur en Al de préférence de 20 à 35 %.

8. Procédé selon l'une des revendications 5 à 7, **caractérisé en ce que** la couche de découplage (5) est réalisée en plusieurs étapes LPE individuelles.

9. Procédé selon l'une des revendications 4 à 8, **caractérisé en ce que** la couche de découplage (5) est réalisée par un procédé LPE à différence de température.
